# EUROPEAN PATENT APPLICATION

(11) **EP 1 347 470 A1**
(43) Date of publication of application: **24.09.2003**
(21) Application number: 03076248.8
(22) Date of filing: 08.07.1993
(51) Int. Cl.: H01C 1/14

(54) **Electrical devices comprising a conductive polymer**

(30) Priority: 09.07.1992 US 910950
(62) Divisional of application: 97202527.4
(71) Applicant: Tyco Electronics Corporation, Middletown, PA 17057-3163 (US)
(72) Inventor: Graves, Gregory A., Troy, MI 48098 (US); Zhang, Michael, Fremont, CA 94555 (US); Chandler, Daniel, Menlo Park, CA 94025 (US); Chang, Chi-Ming, Dept. Chem. Eng., Kowloon, Hong Kong (CN); Fang, Shou-Mean, Union City, CA 94587 (US)
(74) Representative: Jay, Anthony William

(57) **Abstract**

An electrical device which comprises first and second laminar electrodes and a laminar PTC resistive element sandwiched between them, the device comprising
(a) a main portion which comprises a main part of the first electrode, a main part of the second electrode, and a main part of the resistive element; and
(b) a first connection leg which extends away from the main portion and which comprises a first leg part of the first electrode which is integral with the main part of the first electrode, and a first leg part of the resistive element which is integral with the main part of the resistive element.
Such devices can be secured to circuit boards in a variety of ways, and to elastically deformed terminals.

## Description

This invention relates to electrical devices.

Many electrical devices comprise two laminar electrodes and, sandwiched between them, an electrical element which may be a conductor, e.g. a resistive element, as for example in a resistor or a varistor, or a non-conductor, as for example in a capacitor. Particularly useful devices of this type are circuit protection devices which comprise a main portion which is a laminate of two laminar electrodes and, sandwiched between the electrodes, a laminar resistive element which exhibits PTC behavior. The resistive element may be composed of conductive polymer (this term being used to denote a composition comprising a polymer and, dispersed therein, a particulate conductive filler) or a ceramic, e.g. a doped barium titanate. When a conductive polymer is used, such devices are generally prepared by stamping (or otherwise cutting) a plurality of the devices out of a laminate of a sheet of the conductive polymer between two metal foils. When a ceramic is used, such devices are usually prepared by applying liquid electrode material to the major surfaces of a preformed laminar resistive element, and solidifying the liquid electrode material.

The products of such processes can sometimes be used without the addition of electrical leads, for example by installation between two spring-loaded terminals. In most cases, however, an electrical lead must be secured to each of the laminar electrodes, so that the device can be connected to other components of a circuit, e.g. mounted on a circuit board. The addition of leads is an additional expense and usually involves heating (e.g. during soldering or welding) which can cause damage, particularly to conductive polymer elements. The latter problem is particularly severe when a conductive polymer is heated a second time when the leads are connected to other circuit elements, in particular when the leads are connected to a printed circuit board by a soldering process. A further problem which can arise when such devices are to be mounted on a printed circuit board is that they protrude further from the board than is desirable.

We have now realized, in accordance with the present invention, that when at least one of the laminar electrodes of an electrical device as described above is to be connected to an electrical conductor on an insulating substrate, in particular a printed circuit board, then by appropriate modification of the device and/or of the configuration of the electrical conductor on the substrate, the connection can be made either without the need for a lead (or other connecting member), or with the aid of a connecting member which is electrically connected to the electrode in the same step as it is electrically connected to the conductor on the substrate. We have also realized in accordance with the present invention, that such modification can also be extremely valuable for electrical devices which are connected via elastically deformed terminals. The invention will be described herein chiefly by reference by circuit protection devices, but it is also applicable to other devices comprising two laminar electrodes and a laminar element sandwiched between them.

One device of the invention has, in addition to a main portion having its normal configuration (typically a simple geometric shape such as a rectangle or a circle), at least one connection leg which extends away from the main portion and which comprises an extension of the PTC resistive element and an extension of one of the electrodes secured to the PTC element, and optionally also an extension of the other electrode. Such a modified device can be mounted on a circuit board by inserting the end of the connection leg into an aperture in the board and soldering the electrode to a metal conductor which is secured to the board and which leads to the aperture. If the connection leg does not include both electrodes, then the solder connection can be carried out in conventional ways. If the leg does include both electrodes in the region of the aperture, then care must be taken to ensure that the solder connects only the desired electrode to the metal conductor. For this purpose, the metal conductor can lead to one side only of the aperture and preferably can be substantially narrower than the aperture and the face of the connection leg to which it is soldered. A circuit board having a metal conductor and an aperture of this kind is believed to be novel per se and as such forms a part of the present invention. Generally, a device which is to be mounted in this way will be modified so that it has two connection legs of the kind described, extending in the same direction from the main part of the device, so that the legs can be mounted in adjacent apertures in the same circuit board. The legs preferably have distal portions which are inserted into the apertures in the board, and intermediate stand-off portions which cannot pass through the apertures and which ensure that the main part of the device is spaced apart from the board

As discussed above (and in greater detail below), when the device is to be mounted in apertures in a circuit board, the connection leg can comprise both electrodes; preferably, however, the connection leg includes a bridge portion which extends across the full width of the leg and which includes only one of the electrodes, so that the device can be soldered to the circuit board in the conventional way. When the connection leg is of the latter kind, the device can also be mounted flat on top of a circuit board in the following way. The device is placed on the substrate with the electrode which extends into the connection leg on top. A bottom electrode is connected directly to a conductor on the board. The top electrode is connected to another conductor on the board by means of a connection member secured to the top electrode and extending downwards below the lower face of the resistive element. The connection member can be soldered or otherwise electrically connected to the upper electrode before it is electrically connected to the conductor on the board.; alternatively, both electrical connections are made simultaneously so that the resistive element is not exposed twice to the heating required to make such connections. In this method, only one connection leg is necessary, because the lower electrode is already adjacent to the board. However, if there are two connection legs, the device can be placed on the board with either electrode on top, and the connections to the device and the subsequent operation of the device can be the same.

The novel devices of the invention can be made by securing electrodes of appropriate shapes to resistive elements of the desired final shape; or by securing electrode precursors of appropriate shapes to resistive elements which are larger than the desired final shape, and then cutting out a plurality of devices of the desired final shape or shapes; or by cutting out a plurality of devices of the desired final shape or shapes from a simple laminate of constant cross-section and, if desired or necessary, and before or after the cutting out operation, removing unwanted portions of one or both of the electrodes. Such removal can be effected for example by milling or by etching. Preferably such removal of unwanted portions of the electrodes removes little or none of the PTC resistive element, which provides desirable physical strength to the connection leg. Preferably also, when, as is preferred, the connection leg includes only one of the electrodes, the leg does also include a residual portion of the second electrode. The residual portion is not electrically connected to the main portion, but provides valuable physical properties, including strength and resistance to deformation when connection to the first electrode is made by a spring clip or other elastically deformed terminal.

### A BRIEF DESCRIPTION OF THE DRAWING

The invention is illustrated by the drawing, in which
Figure 1 shows a plan view of an electrical assembly of the invention showing an electrical device of the invention mounted on a circuit board;
Figure 2 is a cross-sectional view of an assembly of the invention along line 2-2 of Figure 1;
Figure 3 is a plan view of another electrical assembly of the invention showing an electrical device of the invention mounted on a circuit board;
Figure 4 is a cross-sectional view of an assembly of the invention along line 4-4 of Figure 3;
Figures 5 is a bottom view of the assembly of Figure 3;
Figure 6 is a top view of another assembly of the invention which includes an electrical device of the invention; and
Figure 7 is a cross-sectional view of an assembly of the invention through the thickness of the assembly of Figure 6.

### DETAILED DESCRIPTION OF THE INVENTION

All embodiments and aspects of the invention set out below are to be regarded as part of Applicants' invention, even where the following detailed description is broader than the summary of the invention set out above. The following detailed description should not be regarded as in any way limiting the generality of the summary of the invention set out above.

As described and claimed below, and as illustrated in the accompanying drawings, the present invention can make use of a number of particular features. Where such feature is disclosed in a particular context or as part of a particular combination, it can also be used in other contexts and in other combinations, including for example other combinations of two or more such features.

### PTC Compositions

The PTC compositions used in the present invention are preferably conductive polymers which comprise a crystalline polymer component and, dispersed in the polymer component, a particulate filler component which comprises a conductive filler, e.g. carbon black or a metal. The filler component may also contain a non-conductive filler, which changes not only the electrical properties of the conductive polymer but also its physical properties. Suitable conductive polymers for use in this invention are disclosed for example in U.S. Patent Nos. 4,237,441 (van Konynenburg et al), 4,304,987 (van Konynenburg), 4,388,607 (Toy et al), 4,514,620 (Cheng et al), 4,534,889 (van Konynenburg et al), 4,545,926 (Fouts et al), 4,560,498 (Horsma et al), 4,591,700 (Sopory), 4,724,417 (Au et al), 4,774,024 (Deep et al), 4,935,156 (van Konynenburg), and 5,049,850 (Evans et al), and copending, commonly assigned U.S: Patent Application No. 07/893,626 (Chandler et al, filed June 5, 1992). The disclosure of each of these patents and applications is incorporated herein by reference.

The resistive element can be composed of one or more conductive polymer members, at least one of which is a PTC member. When there is more than one conductive polymer member, the current preferably flows sequentially through the different compositions, as for example when each composition is in the form of a layer which extends across the whole of the main portion of the device. When there is a single PTC composition, and the desired thickness of the PTC element is greater than that which can conveniently be prepared in a single step, a PTC element of the desired thickness can conveniently be prepared by joining together, eg. laminating by means of heat and pressure, two or more layers, eg. melt-extruded layers, of the PTC composition. When there is more than one PTC composition, the PTC element will usually be prepared by joining together, eg. laminating by means of heat and pressure, elements of the different compositions. For example, a PTC element can comprise two laminar elements composed of a first PTC composition. and, sandwiched between them, a laminar element composed of a second PTC composition having a higher resistivity than the first.

When a PTC device is tripped, most of the voltage dropped over the device is normally dropped over a relatively small part of the device which is referred to as the hot line, hot plane or hot zone. In the devices of the invention, the PTC element can have one or more features which help the hot line to form at a desired location, usually spaced apart from both electrodes. Suitable features of this kind for use in the present invention are disclosed for example in U.S. Patents Nos. 4,317,027 and 4,352,083 (Middleman et al), 4,907,340 and 4,924,072 (Fang et al), the disclosures of which are incorporated herein by reference.

### Laminar Electrodes

Particularly useful devices of the invention comprise two metal foil electrodes, and a PTC conductive polymer element sandwiched between them, especially such devices which are used as circuit protection devices and have low resistance at 23°C, generally less than 50 ohm, preferably less than 10 ohm, particularly less than 5 ohm, especially less than 3 ohm. Particularly suitable foil electrodes are disclosed in U.S. Patents Nos. 4,689,475 (Matthieson) and 4,800,253 (Kleiner et al), the disclosure of each of which is incorporated herein by reference. A variety of laminar devices which can be modified in accordance with the present invention are disclosed in U.S. Patent Nos. 4,238,812 (Middleman et al), 4,255,798 (Simon), 4,272,471 (Walker), 4,315,237 (Middleman et al), 4,317,027 (Middleman et al), 4,330,703 (Horsma et al), 4,426,633 (Taylor), 4,475,138 (Middleman et al), 4,472,417 (Au et al), 4,780,598 (Fahey et al), 4,845,838 (Jacobs et al), 4,907,340 (Fang et al), and 4,924,074 (Fang et al), the disclosure of each of which is incorporated herein by reference.

### Devices of the Invention

In a first aspect, the present invention provides an electrical device which comprises
(1) a first laminar electrode;
(2) a second laminar electrode; and
(3) a laminar resistive element which exhibits PTC behavior, and which has a first face to which the first electrode is secured and an opposite second face to which the second electrode is secured;
the device comprising
(a) a main portion which comprises
   (i) a main part of the first electrode,
   (ii) a main part of the second electrode, and
   (iii) a main part of the resistive element;
   and
(b) a first connection leg which extends away from the main portion and which comprises
   (i) a first leg part of the first electrode which is integral with the main part of the first electrode, and
   (ii) a first leg part of the resistive element which is integral with the main part of the resistive element.

The first connection leg can also include a first leg part of the second electrode which is integral with the main part of the second electrode. Preferably, however, the first connection leg includes a residual part of the second electrode which is not connected to the main part of the second electrode and which does not, therefore, play any part of the electrical operation of the device. alternatively, the first leg can consist essentially of the first leg part of the first electrode and the first leg part of the resistive element.

### First Embodiment of the First aspect of the Invention

In this embodiment, the device is designed to be mounted in apertures of a substrate, e.g. a printed circuit board.

The devices of this embodiment preferably also contain
(c) a second connection leg which extends away from the main portion, which is spaced away from the first connection leg, and which comprises
   (i) a second leg part of the second electrode which is integral with the main part of the second electrode, and
   (ii) a second leg part of the resistive element which is integral with the main part of the resistive element.

The second leg can include a second leg part of the first electrode, but preferably includes only a residual part of the first electrode which provides useful physical properties but does not play any part in the electrical operation of the device. Alternatively the second leg can consist essentially of the second leg part of the second electrode and the second leg part of the resistive element. The main portion and the first and second connection legs are preferably substantially coplanar. However, one or both of the legs (or the sole leg, when there is only one) can be inclined to main portion. Generally each of the legs will extend away from the main portion by a distance of at least 0.15 cm, e.g. 0.15 to 1.0 cm, preferably 0.2 to 0.6 cm.

The first and second connection legs preferably extend away from the main portion in substantially the same direction so that they can both be mounted on a planar substrate, with the main portion of the device extending away from the substrate, preferably at right angles thereto.

In these devices, it is preferred that the first connection leg comprises a first distal sub-portion spaced away from the main portion of the device and a first stand-off sub-portion which lies between the first distal sub-portion and the main portion, and the second connection leg comprises a second distal sub-portion spaced away from the main portion of the device and a second stand-off sub-portion which lies between the second distal sub-portion and the main portion, with the distal and stand-off sub-portions being shaped so that when each of the distal sub-portions is placed in an aperture of an appropriate size in the planar substrate, the stand-off sub-portions will not pass through the apertures and wil prevent contact between the substrate and the main portion of the device. Thus one or (preferably) both of the first and second connection legs can be wedge-shaped or can include a step which lies at the junction between the distal and stand-off sub-portions.

When the device is prepared merely by cutting it out from a uniform laminate of the electrode materials and the resistive material, the device will be one in which (a) the first leg part of the first electrode, the first leg part of the resistive element, and a first leg part of the second electrode are substantially coextensive, and (b) a second leg part of the first electrode, the second leg part of the resistive element, and the second leg part of the second electrode are substantially coextensive.

In some cases, however, it is preferred that the device should be one in which the first stand-off sub-portion comprises a first bridge sub-portion which extends across the width of the first connection leg and which does not include any part of the second electrode; and the second stand-off sub-portion comprises a second bridge sub-portion which extends across the width of the second connection leg and does not include any part of the first electrode. Such a device can be prepared by removing a portion of the second electrode from the first connection leg and by removing a portion of the first electrode from the second electrode leg, to give a device in which the first distal sub-portion comprises a second residual conductive member which, in the absence of the first bridge sub-portion, would be integral with the main part of the second electrode; and the second distal sub-portion comprises a first residual conductive member which, in the absence of the second bridge sub-portion, would be integral with the main part of the first electrode. In a device prepared in this way, the second residual conductive member is preferably separated from the second electrode by a distance which is at least as great as the minimum distance between the first and second electrodes at any location on the device, e.g. 1.5 to 4 times that distance, and the first residual conductive member is preferably separated from the first electrode by a distance which is at least as great as the minimum distance between the first and second electrodes at any location on the device, e.g. 1.5 to 4 times that distance. The portion of the electrode which is removed can have a simple shape, e.g. a rectangular strip, or a more complex shape. We have found that the physical strength of the leg can be improved by removing a more complex shape, e.g. a V-shaped portion, of the electrode.

Such a device can also be prepared by removing all of the second electrode from the first connection leg and all of the first electrode from the second connection leg, or by using corresponding preshaped electrodes, in which case the first connection leg is free from any conductive member which, in the absence of the first bridge sub-portion, would be integral with the main part of the second electrode; and the second connection leg is free from any conductive member which, in the absence of the second bridge sub-portion, would be integral with the main part of the first electrode.

### Second Embodiment of the First aspect of the Invention

In this embodiment, the device is designed to be mounted parallel to, preferably spaced apart by a small distance from, a substrate, e.g. a printed circuit board.

In the devices of this embodiment, the first connection leg comprises
(i) a first distal sub-portion which
   (a) is spaced away from the main portion of the device,
   (b) comprises a first distal sub-part of the first leg part of the first electrode, and
   (c) comprises a first electrical connector which contacts the first distal sub-part of the first electrode and extends at least to the second face of the laminar resistive element;
   and
(ii) a first bridge sub-portion which
   (a) lies between the first distal sub-portion and the main portion of the device,
   (b) extends across the width of the first connection leg, and
   (c) does not include any part of the second electrode;
whereby the device can be placed flat on a planar insulating substrate having first and second appropriately spaced-apart metal conductors on the surface thereof, with the first electrical connector adjacent the first metal conductor, and electrical connection can be made (a) between the first metal conductor and the first electrode, through the first electrical connector, and (b) between the second conductor and the second electrode.

Such a device can be made by removing a strip of the second electrode from the first connection leg, to give a device in which the first distal sub-portion comprises a second residual conductive member which is on the second face of the first leg part of the resistive element and which, in the absence of the first bridge sub-portion, would be integral with the main part of the second electrode.

The first electrical connector is preferably one which will remain in place even if it is not bonded to the other parts of the device, for example a U-shaped member which extends around the end of the first leg portion and the first electrode and, if present, the second residual conductive member. The connector can be resilient so that it clamps to the remainder of the device.

So that the device can be placed either way up on the substrate, and/or so that it has balanced electrical properties, the device preferably also contains a second connection leg which extends away from the main portion of the device; which is spaced apart from the first connection leg; which comprises
(i) a second leg part of the second electrode which is integral with the main part of the second electrode, and
(ii) a second leg part of the resistive element which is integral with the main part of the resistive element;
   and which comprises
(iii) a second distal sub-portion which
   (a) is spaced apart from the main portion of the device,
   (b) comprises a second distal sub-part of the second leg part of the second electrode, and
   (c) comprises a second electrical connector which contacts the second distal sub-part of the second electrode and extends at least to the first face of the laminar resistive element;
   and
(iv) a second bridge sub-portion which
   (a) lies between the second distal sub-portion and the main portion of the device,
   (b) extends across the width of the second connection leg, and
   (c) does not include any part of the first electrode;
whereby the device can be placed flat on a planar insulating substrate having first and second appropriately spaced apart metal conductors on the surface thereof, with either the first electrical connector or the second electrical connector adjacent one of the metal conductors, and electrical connection can be made between (a) said electrical connector and metal conductor and (b) the other metal conductor and'the electrode adjacent to the substrate.

The preferred characteristics of the second distal and bridge sub-portions and the second connection part are substantially the same as previously described for the first distal and bridge sub-portions and the first connector.

In these devices the contacting surfaces are preferably coated with solder or tin, or otherwise treated, so that they can all be soldered together in a single step by exposing them to heat.

### Assemblies of the Invention

### First embodiment

In this aspect, the invention provides an electrical assembly which comprises
(A) an insulating substrate having a first aperture therein;
(B) a first metal conductor secured to the insulating substrate and leading to the first aperture; and
(C) an electrical device which comprises
   (1) a first laminar electrode;
   (2) a second laminar electrode; and
   (3) a laminar resistive element which exhibits PTC behavior and which has a first face to which the first electrode is secured and an opposite second face to which the second electrode is secured;
the device comprising
(a) a main portion which comprises
   (i) a main part of the first electrode,
   (ii) a main part of the second electrode, and
   (iii) a main part of the resistive element;
   and
(b) a first connection leg
   which extends away from the main portion,
   which comprises
   (i) a first leg part of the first electrode which is integral with the main part of the first electrode, and
   (ii) a first leg part of the resistive element which is integral with the main part of the resistive element, and
   which has a first distal sub-portion spaced away from the main portion of the device and a first stand-off sub-portion between the first distal sub-portion and the main portion;
the first distal sub-portion including a first distal sub-part of the first electrode and lying within the first aperture of the substrate;
the first stand-off sub-portion lying between the substrate and the main portion of the device;
the first metal conductor being physically and electrically connected to the first distal sub-part of the first electrode; and
all of the electrical current between the first metal conductor and the second electrode of the device passing through the first electrode and the resistive element.

Preferably the insulating substrate has a second aperture therein; a second metal conductor is secured to the insulating substrate and leads to the second aperture; and the device also contains a second connection leg which
(a) extends away from the main portion,
(b) is spaced away from the first connection leg,
(c) comprises
   (i) a second leg part of the second electrode which is integral with the main part of the second electrode, and
   (ii) a second leg part of the resistive element which is integral with the main part of the resistive element, and
(d) has a second distal sub-portion spaced away from the main portion of the device and a second stand-off sub-portion between the second distal sub-portion and the main portion;
the second distal sub-portion including a second distal sub-part of the second electrode and lying within the second aperture of the substrate;
the second metal conductor being physically and electrically connected to the second distal sub-part of the second electrode; and
all of the electrical current between the second metal conductor and the first electrode of the device passing through the second electrode and the resistive element.

In one preferred assembly, the first leg part of the first electrode, the first leg part of the resistive element, and the first leg part of the second electrode are substantially coextensive; the second leg part of the first electrode, the second leg part of the resistive element, and the second leg part of the second electrode are substantially coextensive; the first conductor terminates on one side of the first aperture and is connected by a first solder joint to the first leg part of the first electrode, with the distance between any part of the first solder joint and the second electrode being at least as great as the minimum distance between the first and second electrodes at any location on the device, e.g. 1.5 to 4 times that distance; and the second conductor terminates on one side of the second aperture and is connected by a second solder joint to the second leg part of the second electrode, with the distance between any part of the second solder joint and the first electrode being at least as great as the minimum distance between the first and second electrodes at any location on the device, e.g. 1.5 to 4 times that distance.

In another preferred assembly
(a) the first stand-off sub-portion comprises a first bridge sub-portion which extends across the width of the first connection leg and which does not include any part of the second electrode
(b) the second stand-off sub-portion comprises a second bridge sub-portion which extends across the width of the second connection leg and does not include any part of the first electrode;
(c) the first distal sub-portion comprises a second residual conductive member which, in the absence of the first bridge sub-portion, would be integral with the main part of the second electrode;
(d) the second distal sub-portion comprises a first residual conductive member which, in the absence of the second bridge sub-portion, would be integral with the main part of the first electrode; and
(e) the first conductor is connected by a first solder joint to the first leg part of the first electrode, with the distance between any part of the first solder joint and the second electrode being at least as great as the minimum distance between the first and second electrodes at any location on the device; and the second conductor is connected by a second solder joint to the second leg part of the second electrode, with the distance between any part of the second solder joint and the first electrode being at least as great as the minimum distance between the first and second electrodes at any location on the device.

### Second embodiment

In this aspect, the invention provides an electrical assembly which comprises
(A) a planar insulating substrate;
(B) a first metal conductor secured to the insulating substrate;
(C) a second metal conductor secured to the insulating substrate; and
(D) an electrical device which comprises
   (1) a first laminar electrode;
   (2) a second laminar electrode; and
   (3) a laminar resistive element which exhibits PTC behavior and which has a first face to which the first electrode is secured and an opposite second face to which the second electrode is secured;
the device comprising
(a) a main portion which comprises
   (i) a main part of the first electrode,
   (ii) a main part of the second electrode, and
   (iii) a main part of the resistive element;
   and
(b) a first connection leg
   which extends away from the main portion,
   which comprises
   (i) a first leg part of the first electrode which is integral with the main part of the first electrode,
   (ii) a first leg part of the resistive element which is integral with the main part of the resistive element,
   (iii) a first distal sub-portion which
      is spaced away from the main portion of the device, comprises a first distal sub-part of the first leg part of the first electrode, and
      comprises a first electrical connector which contacts the first distal sub-part of the first electrode and extends beyond the second face of the laminar resistive element;
      and
   (iv) a first bridge sub-portion which
      lies between the first distal sub-portion and the main portion of the device,
      extends across the width of the first connection leg, and
      does not include any part of the second electrode;
the device being placed generally parallel to the planar insulating substrate with the second electrode being closer to the substrate than the first electrode, the first electrical connector being connected to the first metal conductor, and the second electrical conductor being connected to the second electrode.

In such an assembly, the device preferably also contains a second connection leg which extends away from the main portion of the device; which is spaced apart from the first connection leg; which comprises
(i) a second leg part of the second electrode which is integral with the main part of the second electrode, and
(ii) a second leg part of the resistive element which is integral with the main part of the resistive element;
and which comprises
(i) a second distal sub-portion which
   (a) is spaced apart from the main portion of the device,
   (b) comprises a second distal sub-part of the second leg part of the second electrode, and
   (c) comprises a second electrical connector which contacts the second distal sub-part of the second electrode and extends beyond the first face of the laminar resistive element;
   and
(ii) a second bridge sub-portion which
   (a) lies between the second distal sub-portion and the main portion of the device,
   (b) extends across the width of the second connection leg, and
   (c) does not include any part of the first electrode.

Preferably there is a solder joint between each of
(a) the first electrical connector and the first electrode,
(b) the first electrical connector and the first metal conductor, and
(c) the second electrode and the second metal conductor, or between the second electrode and an intermediate connector and between the intermediate connector and the second metal conductor, the intermediate connector lying between the second electrode and the second metal conductor.

### DETAILED DESCRIPTION OF THE DRAWING

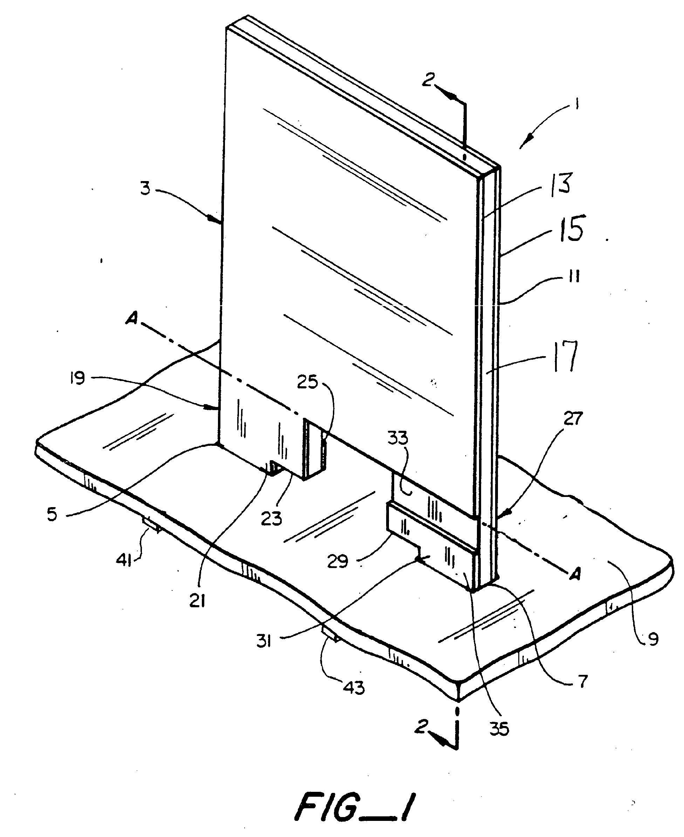

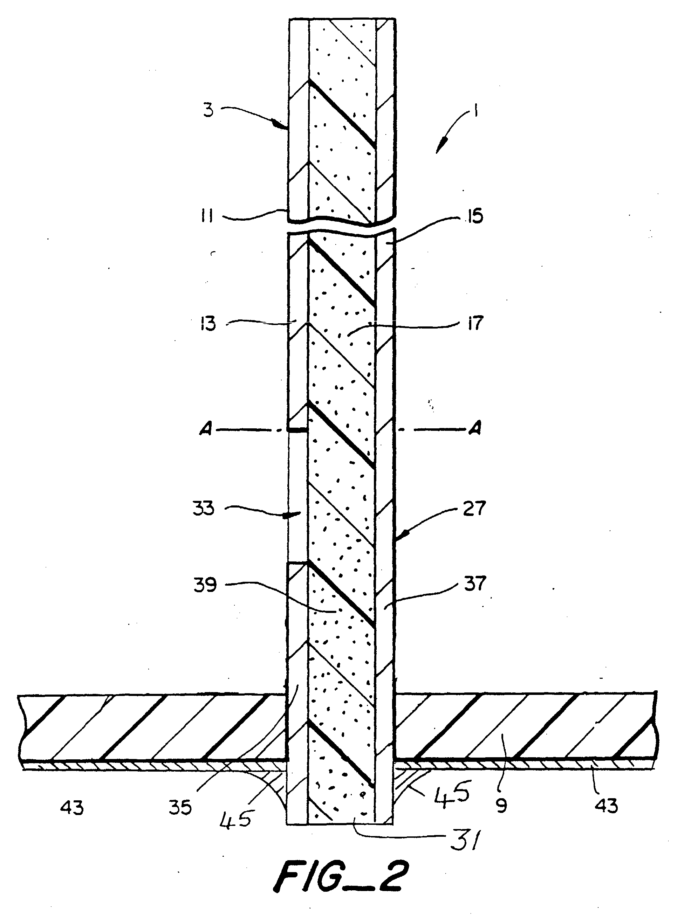

The invention is illustrated by the drawing in which Figure 1 shows an electrical assembly 1 of the invention and Figure 2 shows a cross-section of electrical assembly 1 along line 2-2 of Figure 1. In both Figures 1 and 2, an electrical device 3 of the invention is mounted into first aperture 5 and second aperture 7 on an insulating planar substrate 9, e.g. a circuit board. The section of electrical device 3 above line A-A is the main portion 11, in which the main part of the first laminar electrode 13 and the main part of the second laminar electrode 15, shown in these Figures as metal foil electrodes, are attached to the main part of the laminar resistive element 17, here a conductive polymer which exhibits PTC behavior. Device 3 comprises two connection legs 19 and 27 which are coplanar and extend away from main portion 11 and are used to insert device 3 into the substrate 9. First connection leg 19 comprises a first leg part of the first electrode and a first leg part of the resistive element. In addition, first connection leg 19 comprises a first distal sub-portion 21, a first stand-off sub-portion, shown here in the form of a step, and a first bridge sub-portion 25 (on the back surface of Figure 1). Second connection leg 27 comprises a second stand-off sub-portion 29, second distal sub-portion 31 which lies at least partly within the second aperture 7, and second bridge sub-portion 33. Second distal sub-portion 31 includes the second distal subpart of the second electrode and lies within the second aperture 7 of the substrate. As shown in Figure 2, below line A-A lie a first residual conductive member 35 which is part of the second connection leg 27, as well as the second leg part of the second electrode 37 and the second leg part of the resistive element 39. In order to make electrical contact to the electrical device 3, connection is made between the electrical device 3 and the first metal conductor 41, a conductive trace which leads to the first aperture and is secured to the substrate, and between the electrical device 3 and the second metal conductor 43 which leads to the second aperture and is secured to the substrate. As shown in Figure 2, solder 45 is used to make connection between second metal conductor 43 and the second laminar electrode 15, as well as between the second metal conductor 43 and the residual part of the electrode 13.

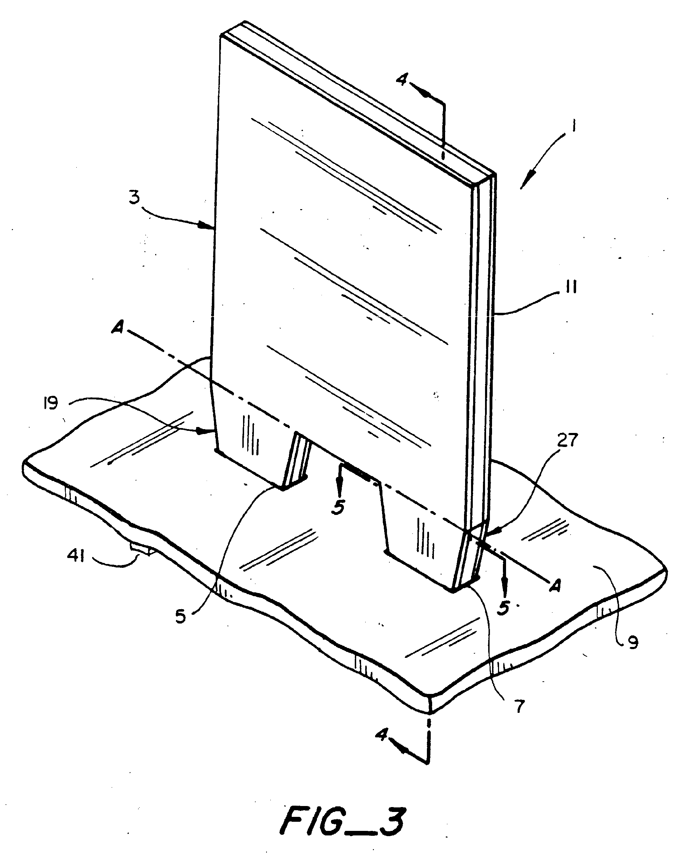

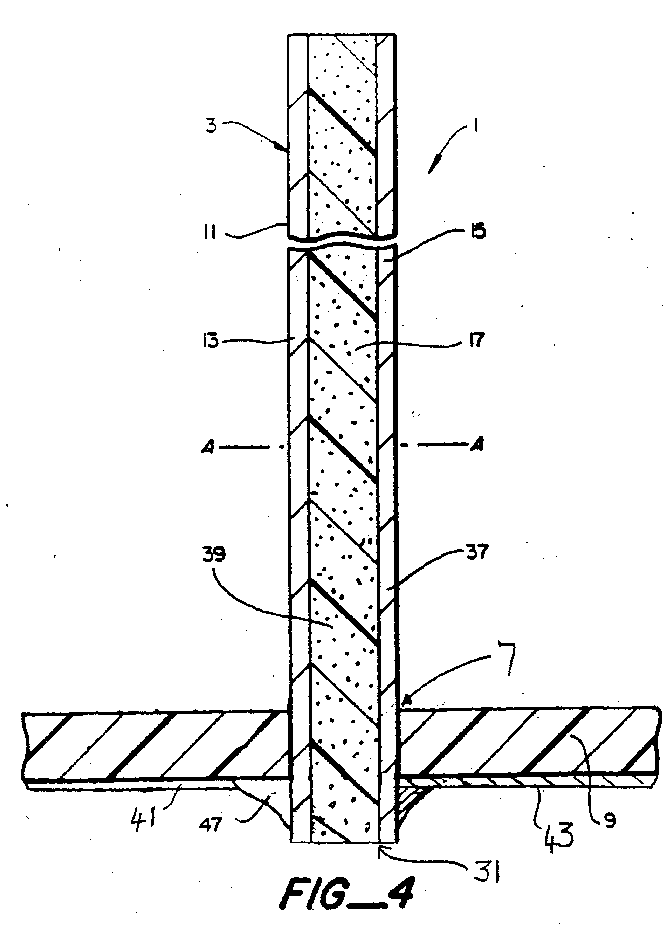

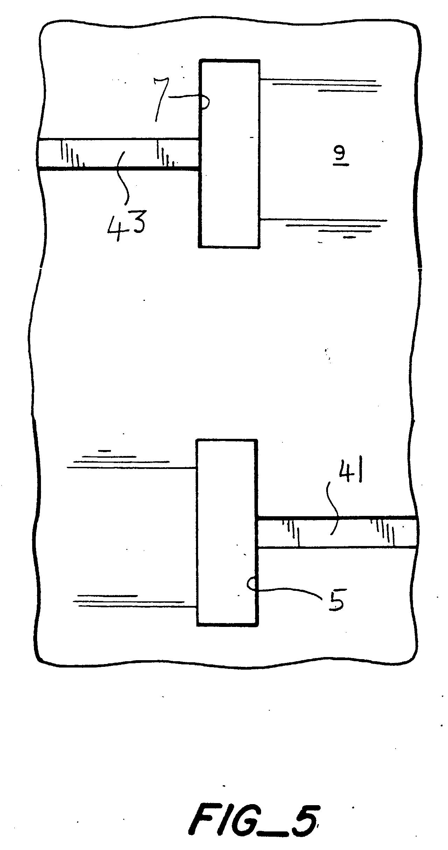

Figure 3 shows a plan view of another electrical assembly 1 of the invention, Figure 4 shows a cross-section of electrical assembly 1 along line 4-4 of Figure 3, and Figure 5 is a bottom view of the assembly of Figure 3 along line 5-5 before and after insertion and electrical connection of a device of the invention. As shown in Figures 1 and 2, electrical device 3 is inserted onto insulating planar substrate 9 through first aperture 5 and second aperture 7 by means of first connection leg 19 and second connection leg 27, respectively. For this device, the first connection leg 19 and the second connection leg 27 are in the form of wedges, and neither a first bridge sub-portion nor a second bridge-sub-portion is present. In Figure 4, the second distal sub-portion 31 of the second connection leg 27 is visible, and, below line A-A, the second leg part of the first electrode 37 and the second leg part of the resistive element 39 are shown. First metal conductor 41 leads to and terminates on one side of first aperture 5, and second metal conductor 43 leads to and terminates on the opposite side of second aperture 7. As shown in Figure 4, electrical connection is made between the first laminar electrode 13 and the first metal conductor 43 by means of solder joint 47.

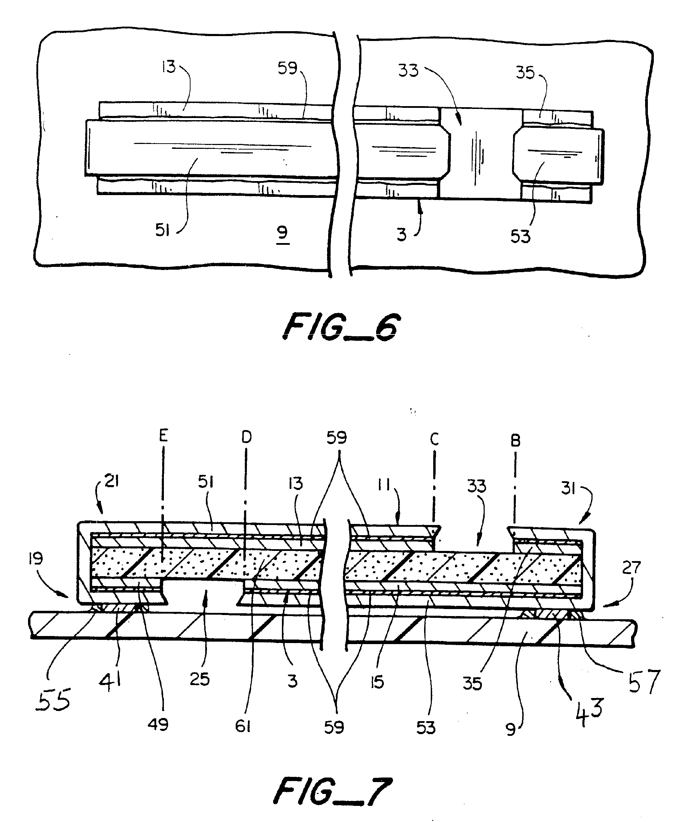

Figure 6 is a top view of another assembly 1 of the invention and Figure 7 is a cross-sectional view through the thickness of the assembly 1 in which the electrical device 3 is suitable for installing as a surface mounted device. In this assembly, the electrical device 3 comprises a laminar resistive element 61 which is laminated to the main portion of the first electrode 13 and the first residual conductive member 35 and to the main portion of the second electrode 15 and the second residual conductive member 49. (The main portion 11 of the device lies between lines C and D.) Attached to first connection leg 19 around first distal sub-portion 21 is U-shaped first connector 51. Attached to second connection leg 27 around second distal sub-portion 31 is U-shaped second connector 53. A solder joint 59 lies between the periphery of the first connector 51 and the first electrode 13 and between the periphery of the second connector 53 and the second electrode 15. First bridge sub-portion 25 lies between lines D and E and second bridge sub-portion 33 lies between lines B and C. Electrical connection is made from the first connector 51 to a first metal conductor 41 secured to insulating substrate 9 by means of first solder joint 55, and from the second connector 53 to second metal connector 43 secured to the insulating substrate 9 by means of second solder joint 57.

The invention is illustrated by the following Examples.

### Example 1

A conductive polymer composition was prepared by pre blending 48.6% by weight high density polyethylene (Petrothene LB832, available from USI) with 51.4% by weight carbon black (Raven 430, available from Columbian Chemicals). The blend was mixed in a Banbury mixer, and the resulting composition was extruded through a 63.5 mm (2.5 inch) extruder to form a sheet with a thickness of 0.51 mm (0.020 inch). Two sheets of extrudate were laminated together to give a sheet with a thickness of about 1 mm (0.040 inch). The sheet was laminated on each side with 0.025 mm (0.001 inch) thick electrodeposited nickel foil (available from Fukuda) and the laminate was irradiated to a dose of 10 Mrad using a 4.5 MeV electron beam. An electrical device with a shape as shown in Figure 1 was cut from the irradiated sheet. The main portion had a width of approximately 7.75 mm (0.305 inch) and a length of approximately 19.7 mm (0.775 inch). The first connection leg and the second connection leg each had a length of 5.25 mm (0.207 inch). There was a maximum distance between the first and second connection legs at the first and second distal sub-portions of 3.8 mm (0.150) inch, and a distance between the step of the first standoff sub-portion and the step of the second standoff sub-portion of 2.0 mm (0.080 inch). The length of the first bridge sub-portion on the first connection leg and of the second bridge sub-portion on the second connection leg was 1.27 mm (0.05 inch). The first and second bridge sub-portions were created by scoring the nickel foil and peeling it completely away from the conductive polymer resistive element.

The first and second connection legs of the electrical device were inserted into first and second apertures, respectively, of a printed circuit board to form an assembly. The assembly was then wave-soldered, causing the electrical traces on the circuit board leading to the first and second apertures to be connected by solder to the first and second connection legs, respectively, as shown in Figure 2. Solder completely surrounded the first and second connection legs.

### Example 2

A conductive polymer composition was mixed, extruded, laminated, and irradiated as in Example 1. An electrical device with a shape as shown in Figure 3 was cut from the irradiated sheet The main portion had a width of approximately 7.8 mm (0.307 inch) and a length of 21 mm (0.827 inch). The first and second leg portions each had a length of 4 mm (0.157 inch) and tapered from a maximum of 2.5 mm (0.098 inch) at the junction with the main portion to a minimum of 1.75 mm (0.068 inch) at the first distal sub-portion and the second distal sub-portion. No bridge sub-portions were created.

The first and second connection legs of the electrical device were inserted into first and second apertures, as in Example 1. In this case, however, the electrical traces on the circuit board made contact with only one of the electrodes. Thus when the assembly was subjected to wave soldering, only one side of the device was electrically connected to each of the traces, as shown in Figures 4 and 5.

## Claims

1. An electrical device, preferably a circuit protection device having a resistance at 23°C of less than 50 ohms, which comprises
(1) a first laminar electrode (13), preferably a metal foil;
(2) a second laminar electrode (15), preferably a metal foil; and
(3) a laminar resistive element (61) which exhibits PTC behavior, preferably a PTC conductive polymer, and which has a first face to which the first electrode is secured and an opposite second face to which the second electrode is secured;
the device comprising
(a) a main portion (11, C-D) which comprises
(i) a main part of the first electrode (13),
(ii) a main part of the second electrode (15), and
(iii) a main part of the resistive element (61); and
(b) a first connection leg (19) which extends away from the main portion and which comprises
(i) a first leg part of the first electrode (13) which is integral with the main part of the first electrode (13), and
(ii) a first leg part of the resistive element (61) which is integral with the main part of the resistive element (61).

2. A device according to claim 1 which also contains
(c) a second connection leg (27) which extends away from the main portion (11, C-D) of the device, which is spaced away from the first connection leg, and which comprises
(i) a second leg part of the second electrode (15) which is integral with the main part of the second electrode, and
(ii) a second leg part of the resistive element (61) which is integral with the main part of the resistive element (61).

3. A device according to claim 2 wherein
the first connection leg contains a first leg part of the second electrode which is integral with the main part of the second electrode;
the second connection leg contains a second leg part of the first electrode which is integral with the main part of the first electrode;
the first leg part of the first electrode, the first leg part of the resistive element, and a first leg part of the second electrode are substantially coextensive; and
a second leg part of the first electrode, the second leg part of the resistive element, and the second leg part of the second electrode are substantially coextensive.
Please cancel original claim 5.

4. A device according to claim 1 wherein the laminar resistive element is composed of conductive polymer, and each of the electrodes is a metal foil.

5. A device according to claim 4 wherein the conductive polymer comprises a crystalline polymer component, and dispersed in the polymer component, a particulate conductive filler.

6. A device according to claim 5 wherein the conductive filler comprises carbon black or metal.

7. A device according to any one of the preceding claims, which has a resistance of less than 10 ohms, preferably less than 5 ohms.
